# EUROPEAN PATENT APPLICATION

(11) **EP 1 930 485 A1**
(43) Date of publication of application: **11.06.2008**
(21) Application number: 06796499.9
(22) Date of filing: 17.08.2006
(51) Int. Cl.: C30B 29/38, C23C 16/34, C23C 16/46, C30B 25/10

(54) **METHOD FOR PRODUCTION OF GaxIn1-xN (0 x 1) CRYSTAL, GaxIn1-xN (0 x 1) CRYSTAL SUBSTRATE, METHOD FOR PRODUCTION OF GaN CRYSTAL, GaN CRYSTAL SUBSTRATE AND PRODUCT**

(30) Priority: 25.08.2005 JP 2005244328; 15.05.2006 JP 2006135212
(71) Applicant: Sumitomo Electric Industries, Ltd., Osaka-shi, Osaka 541-0041 (JP)
(72) Inventor: UEMURA, Tomoki, Itami-shi Hyogo 664-8611 (JP); FUJIWARA, Shinsuke, Itami-shi Hyogo 664-8611 (JP); OKAHISA, Takuji, Itami-shi Hyogo 664-8611 (JP); HIROTA, Ryu, Itami-shi Hyogo 664-8611 (JP); NAKAHATA, Hideaki, Itami-shi Hyogo 664-8611 (JP)
(74) Representative: Grünecker, Kinkeldey, Stockmair & Schwanhäusser Anwaltssozietät
(86) International application number: PCT/JP2006/316142
(87) International publication number: WO 2007/023722

(57) **Abstract**

It seems that a conventional method for producing a GaN crystal by using HVPE has a possibility that the crystallinity of a GaN crystal can be improved by producing a GaN crystal at a temperature higher than 1100°C. However, such a conventional method has a problem in that a quartz reaction tube (1) is melted when heated by heaters (5) and (6) to a temperature higher than 1100°C.

Disclosed herein is a method for producing a GaₓIn₁₋ₓN (0≤x≤1) crystal (12) by growing GaₓIn₁₋ₓN (0≤x≤1) crystal (12) on the surface of a base substrate (7) by the reaction of a material gas, containing ammonia gas and at least one of a gallium halide gas and an indium halide gas, in a quartz reaction tube (1), wherein during the growth of GaₓIn₁₋ₓN (0≤x≤1) crystal (12), quartz reaction tube (1) is externally heated and base substrate (7) is individually heated.

## Description

### Technical Field

The present invention relates to a method for producing a GaₓIn₁₋ₓN (0≤x≤1) crystal, a GaₓIn₁₋ₓN (0≤x≤1) crystalline substrate, and a product including the GaₓIn₁₋ₓN (0≤x≤1) crystalline substrate. More particularly, the present invention relates to a GaₓIn₁₋ₓN (0≤x≤1) crystal production method capable of producing a GaₓIn₁₋ₓN (0≤x≤1) crystal having good crystallinity, a GaₓIn₁₋ₓN (0≤x≤1) crystalline substrate obtained by using such a production method, and a product including the GaₓIn₁₋ₓN (0≤x≤1) crystalline substrate.

The present invention also relates to a method for producing a GaN crystal, a GaN crystalline substrate, and a product including the GaN crystalline substrate. More particularly, the present invention relates to a GaN crystal production method capable of producing a GaN crystal having good crystallinity, a GaN crystalline substrate obtained by using such a production method, and a product including the GaN crystalline substrate.

### Background Art

Among GaₓIn₁₋ₓN (0≤x≤1) crystals, a GaN (gallium nitride) crystal has an energy band gap of 3.4 eV and high heat conductivity, and is therefore receiving attention as a material for semiconductor devices such as short-wavelength optical devices and power electronic devices.

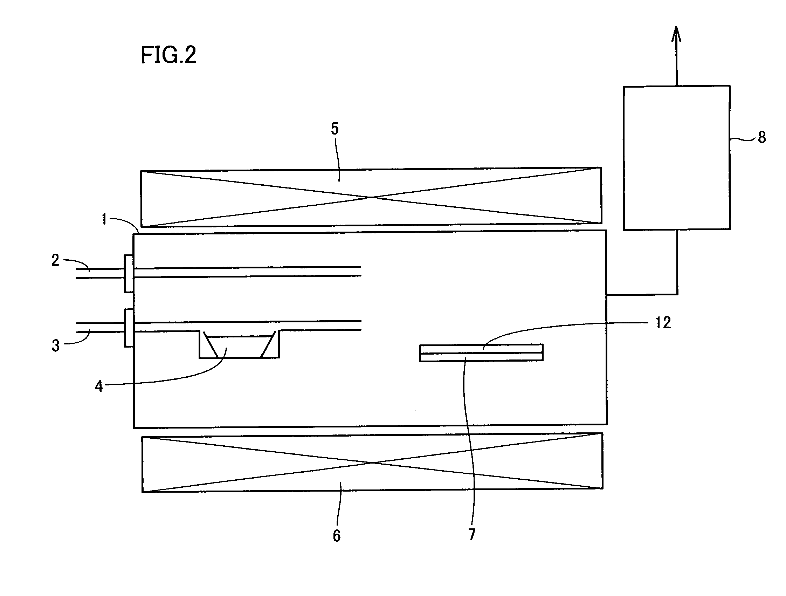

As a method for producing such a GaN crystal, an HVPE (Hydride Vapor Phase Epitaxy) method is conventionally used. Fig. 2 is a schematic diagram showing the structure of one example of production equipment for use in a conventional method for producing a GaN crystal by using HVPE. The production equipment includes a quartz reaction tube 1, gas inlet tubes 2 and 3 for introducing a gas into quartz reaction tube 1, and an exhaust gas treatment apparatus 8 connected to quartz reaction tube 1.

Inside quartz reaction tube 1, a gallium source boat 4 containing gallium (Ga) therein and a base substrate 7 are placed. Then, a carrier gas, such as nitrogen (N₂) gas, argon (Ar) gas, or hydrogen (H₂) gas, is introduced through gas inlet tubes 2 and 3 into quartz reaction tube 1, and gallium source boat 4 and base substrate 7 are heated to about 1000°C by heaters 5 and 6. Then, ammonia (NH₃) gas is introduced through gas inlet tube 2 into quartz reaction tube 1, and hydrogen chloride (HCl) gas is introduced through gas inlet tube 3 into quartz reaction tube 1. As a result, first of all, the gallium reacts with the hydrogen chloride gas to form gallium chloride (GaCl) gas. Then, the gallium chloride gas reacts with the ammonia gas so that a GaN crystal 12 is grown on the surface of base substrate 7. After the completion of the growth of GaN crystal 12, heating by heaters 5 and 6 is stopped to cool gallium source boat 4, GaN crystal 12, and base substrate 7 to around room temperature. Thereafter, base substrate 7 having GaN crystal 12 grown on the surface thereof is taken out of quartz reaction tube 1, and then base substrate 7 is removed by grinding to obtain GaN crystal 12.
Patent Document 1: Japanese Patent Application Laid-open No. 2001-181097

### Disclosure of the Invention

### Problems to be Solved by the Invention

It seems that such a conventional method for producing a GaN crystal by using HVPE has a possibility that the crystallinity of a GaN crystal can be improved by producing it at a temperature higher than 1100°C. However, in fact, quartz reaction tube 1 is melted when heated by heaters 5 and 6 to a temperature higher than 1100°C, and therefore a GaN crystal has never been produced by heating quartz reaction tube 1 by heaters 5 and 6 to a temperature higher than 1100°C.

It is therefore an object of the present invention to provide a GaₓIn₁₋ₓN (0≤x≤1) crystal production method capable of producing a GaₓIn₁₋ₓN (0≤x≤1) crystal having good crystallinity, a GaₓIn₁₋ₓN (0≤x≤1) crystalline substrate obtained by using such a production method, and a product including the GaₓIn₁₋ₓN (0≤x≤1) crystalline substrate.

Another object of the present invention is to provide a GaN crystal production method capable of producing a GaN crystal having good crystallinity, a GaN crystalline substrate obtained by using such a production method, and a product including the GaN crystalline substrate.

### Means for Solving the Problems

The present invention is directed to a method for producing a GaₓIn₁₋ₓN (0≤x≤1) crystal by growing a GaₓIn₁₋ₓN (0≤x≤1) crystal on the surface of a base substrate by the reaction of a material gas, containing ammonia gas and at least one of a gallium halide gas and an indium halide gas, in a quartz reaction tube, wherein during the growth of the GaₓIn₁₋ₓN (0≤x≤1) crystal, the quartz reaction tube is externally heated and the base substrate is individually heated.

In the method for producing a GaₓIn₁₋ₓN (0≤x≤1) crystal according to the present invention, the base substrate can be individually heated by a heater provided on the back surface side of the base substrate.

Further, in the method for producing a GaₓIn₁₋ₓN (0≤x≤1) crystal according to the present invention, the base substrate can be individually heated by utilizing a high-frequency induction heating system.

Furthermore, in the method for producing a GaₓIn₁₋ₓN (0≤x≤1) crystal according to the present invention, the gallium halide gas can be formed by the reaction between gallium and a halogen gas.

Moreover, in the method for producing a GaₓIn₁₋ₓN (0≤x≤1) crystal according to the present invention, the indium halide gas can be formed by the reaction between indium and a halogen gas.

Moreover, in the method for producing a GaₓIn₁₋ₓN (0≤x≤1) crystal according to the present invention, hydrogen chloride gas can be used as the halogen gas.

Moreover, in the method for producing a GaₓIn₁₋ₓN (0≤x≤1) crystal according to the present invention, the base substrate is preferably made of any one of silicon, sapphire, silicon carbide, gallium nitride, and aluminum nitride.

Moreover, in the method for producing a GaₓIn₁₋ₓN (0≤x≤1) crystal according to the present invention, the grown GaₓIn₁₋ₓN (0≤x≤1) crystal can have an impurity concentration of 1 × 10¹⁸ cm⁻³ or less.

Moreover, in the method for producing a GaₓIn₁₋ₓN (0≤x≤1) crystal according to the present invention, the grown GaₓIn₁₋ₓN (0≤x≤1) crystal can contain, as an impurity, at least one selected from the group consisting of carbon, magnesium, iron, beryllium, zinc, vanadium, and antimony at a concentration of 1 × 10¹⁷ cm⁻³ or higher, and can have a specific resistance of 1 × 10⁴ Ωcm or higher.

Moreover, in the method for producing a GaₓIn₁₋ₓN (0≤x≤1) crystal according to the present invention, the GaₓIn₁₋ₓN (0≤x≤1) crystal can be grown to dope with an n-type impurity.

Moreover, in the method for producing a GaₓIn₁₋ₓN (0≤x≤1) crystal according to the present invention, the grown GaₓIn₁₋ₓN (0≤x≤1) crystal can contain, as the n-type impurity, at least one selected from the group consisting of oxygen, silicon, sulfur, germanium, selenium, and tellurium at a concentration of 1 × 10¹⁷ CM⁻³ or higher, and can have a specific resistance of 1 Ωcm or lower.

Moreover, in the method for producing a GaₓIn₁₋ₓN (0≤x≤1) crystal according to the present invention, the grown GaₓIn₁₋ₓN (0≤x≤1) crystal can contain, as an impurity, at least one selected from the group consisting of carbon, oxygen, and silicon, and can have an n_{eff} of 1 × 10¹⁷ cm⁻³ or higher but 1 × 10¹⁹ cm⁻³ or lower, the n_{eff} being represented by the following formula: n_{eff} = nₒ + nₛᵢ - n_{c} (where n_{c} is a carbon content, nₒ is an oxygen content, and nₛᵢ is a silicon content), and can have a specific resistance of 0.1 Ωcm or lower.

Moreover, in the method for producing a GaₓIn₁₋ₓN (0≤x≤1) crystal according to the present invention, the grown GaₓIn₁₋ₓN (0≤x≤1) crystal preferably has the carbon content n_{c} of 5 × 10¹⁵ cm⁻³ or higher but lower than 1 × 10¹⁷ cm⁻³, the oxygen content nₒ of 1 × 10¹⁷ cm⁻³ or higher but 2 × 10¹⁸ cm⁻³ or lower, the silicon content nₛᵢ of 1 × 10¹⁷ cm⁻³ or higher but 2 × 10¹⁸ cm⁻³ or lower, and a specific resistance of 0.01 Ωcm or higher but 0.1 Ωcm or lower.

Moreover, in the method for producing a GaₓIn₁₋ₓN (0≤x≤1) crystal according to the present invention, the grown GaₓIn₁₋ₓN (0≤x≤1) crystal can have a thickness of 200 µm or more.

Moreover, in the method for producing a GaₓIn₁₋ₓN (0≤x≤1) crystal according to the present invention, during the growth of the GaₓIn₁₋ₓN (0≤x≤1) crystal, the temperature of the base substrate is preferably higher than 1100°C but 1400°C or lower.

Moreover, in the method for producing a GaₓIn₁₋ₓN (0≤x≤1) crystal according to the present invention, during the growth of the GaₓIn₁₋ₓN (0≤x≤1) crystal, the temperature of the base substrate is preferably higher than 1150°C but 1400°C or lower.

Moreover, in the method for producing a GaₓIn₁₋ₓN (0≤x≤1) crystal according to the present invention, during the growth of the GaₓIn₁₋ₓN (0≤x≤1) crystal, the temperature of the quartz reaction tube externally heated is preferably 800°C or higher but 1100°C or lower, and the temperature of the base substrate is preferably higher than 1100°C but 1400°C or lower.

Moreover, in the method for producing a GaₓIn₁₋ₓN (0≤x≤1) crystal according to the present invention, during the growth of the GaₓIn₁₋ₓN (0≤x≤1) crystal, the temperature of the quartz reaction tube externally heated is preferably 800°C or higher but 950°C or lower, and the temperature of the base substrate is preferably higher than 950°C but 1400°C or lower.

The present invention is also directed to a method for producing a GaₓIn₁₋ₓN (0≤x≤1) crystal by growing a GaₓIn₁₋ₓN (0≤x≤1) crystal on the surface of a base substrate by the reaction of a material gas, containing ammonia gas and at least one of a gallium halide gas and an indium halide gas, in a quartz reaction tube, wherein during the growth of the GaₓIn₁₋ₓN (0≤x≤1) crystal, the temperature of the base substrate is higher than 1100°C but 1400°C or lower.

The present invention is also directed to a method for producing a GaₓIn₁₋ₓN (0≤x≤1) crystal by growing a GaₓIn₁₋ₓN (0≤x≤1) crystal on the surface of a base substrate by the reaction of a material gas, containing ammonia gas and at least one of a gallium halide gas and an indium halide gas, in a quartz reaction tube, wherein during the growth of the GaₓIn₁₋ₓN (0≤x≤1) crystal, the temperature of the base substrate is higher than 1150°C but 1400°C or lower.

The present invention is also directed to a GaₓIn₁₋ₓN (0≤x≤1) crystalline substrate composed of a GaₓIn₁₋ₓN (0≤x≤1) crystal obtained by any one of the above-described methods for producing a GaₓIn₁₋ₓN (0≤x≤1) crystal.

The present invention is also directed to a product including the GaₓIn₁₋ₓN (0≤x≤1) crystalline substrate. The present invention is also directed to a method for producing a GaN crystal by growing a GaN crystal on the surface of a base substrate by the reaction of a material gas, containing a gallium halide gas and ammonia gas, in a quartz reaction tube, wherein during the growth of the GaN crystal, the quartz reaction tube is externally heated and the base substrate is individually heated.

In the method for producing a GaN crystal according to the present invention, the base substrate can be individually heated by a heater provided on the back surface side of the base substrate.

Further, in the method for producing a GaN crystal according to the present invention, the base substrate can be individually heated by utilizing a high-frequency induction heating system.

Furthermore, in the method for producing a GaN crystal according to the present invention, the gallium halide gas can be formed by the reaction between gallium and a halogen gas.

Moreover, in the method for producing a GaN crystal according to the present invention, hydrogen chloride gas can be used as the halogen gas.

Moreover, in the method for producing a GaN crystal according to the present invention, the grown GaN crystal can have an impurity concentration of 1 × 10¹⁸ cm⁻³ or less.

Moreover, in the method for producing a GaN crystal according to the present invention, the grown GaN crystal can contain, as an impurity, at least one selected from the group consisting of carbon, magnesium, iron, beryllium, zinc, vanadium, and antimony at a concentration of 1 × 10¹⁷ cm⁻³ or higher, and can have a specific resistance of 1 × 10⁴ Ωcm or higher.

Moreover, in the method for producing a GaN crystal according to the present invention, the GaN crystal can be grown to dope with an n-type impurity.

Moreover, in the method for producing a GaN crystal according to the present invention, the grown GaN crystal can contain, as the n-type impurity, at least one selected from the group consisting of oxygen, silicon, sulfur, germanium, selenium, and tellurium at a concentration of 1 × 10¹⁷ cm⁻³ or higher, and can have a specific resistance of 1 Ωcm or lower.

Moreover, in the method for producing a GaN crystal according to the present invention, the grown GaN crystal can contain, as an impurity, at least one selected from the group consisting of carbon, oxygen, and silicon, and can have an n_{eff} of 1 × 10¹⁷ cm⁻³ or higher but 1 × 10¹⁹ cm⁻³ or lower, the n_{eff} being represented by the following formula: n_{eff} = nₒ + nₛᵢ - n_{c} (where n_{c} is a carbon content, nₒ is an oxygen content, and nₛᵢ is a silicon content), and can have a specific resistance of 0.1 Ωcm or lower.

Moreover, in the method for producing a GaN crystal according to the present invention, the grown GaN crystal preferably has the carbon content n_{c} of 5 x 10¹⁵ cm⁻³ or higher but lower than 1 × 10¹⁷ cm⁻³, the oxygen content nₒ of 1 × 10¹⁷ cm⁻³ or higher but 2 × 10¹⁸ cm⁻³ or lower, the silicon content nₛᵢ of 1 × 10¹⁷ cm⁻³ or higher but 2 × 10¹⁸ cm⁻³ or lower, and a specific resistance of 0.01 Ωcm or higher but 0.1 Ωcm or lower.

Moreover, in the method for producing a GaN crystal according to the present invention, the grown GaN crystal can have a thickness of 200 µm or more.

Moreover, in the method for producing a GaN crystal according to the present invention, the base substrate is preferably made of gallium nitride.

Moreover, in the method for producing a GaN crystal according to the present invention, the surface of the base substrate preferably has an arithmetic mean roughness Ra of 10 µm or less.

Moreover, in the method for producing a GaN crystal according to the present invention, during the growth of the GaN crystal, the temperature of the base substrate is preferably higher than 1100°C but 1300°C or lower.

Moreover, in the method for producing a GaN crystal according to the present invention, during the growth of the GaN crystal, the temperature of the base substrate is preferably higher than 1150°C but 1250°C or lower.

Moreover, in the method for producing a GaN crystal according to the present invention, during the growth of the GaN crystal, the temperature of the quartz reaction tube externally heated is preferably 800°C or higher but 1100°C or lower, and the temperature of the base substrate is preferably higher than 1100°C but 1300°C or lower.

Moreover, in the method for producing a GaN crystal according to the present invention, during the growth of the GaN crystal, the temperature of the quartz reaction tube externally heated is preferably 800°C or higher but 950°C or lower, and the temperature of the base substrate is preferably higher than 950°C but 1300°C or lower.

Moreover, in the method for producing a GaN crystal according to the present invention, during the growth of the GaN crystal, the temperature of the quartz reaction tube externally heated is preferably 800°C or higher but 1100°C or lower, and the temperature of the base substrate is preferably higher than 1150°C but 1250°C or lower.

Moreover, in the method for producing a GaN crystal according to the present invention, during the growth of the GaN crystal, the temperature of the quartz reaction tube externally heated is preferably 800°C or higher but 950°C or lower, and the temperature of the base substrate is preferably higher than 1150°C but 1250°C or lower.

The present invention is also directed to a method for producing a GaN crystal by growing a GaN crystal on the surface of a base substrate by the reaction of a material gas, containing a gallium halide gas and ammonia gas, in a quartz reaction tube, wherein during the growth of the GaN crystal, the temperature of the base substrate is higher than 1100°C but 1300°C or lower.

The present invention is also directed to a method for producing a GaN crystal by growing a GaN crystal on the surface of a base substrate by the reaction of a material gas, containing a gallium halide gas and ammonia gas, in a quartz reaction tube, wherein during the growth of the GaN crystal, the temperature of the base substrate is higher than 1150°C but 1250°C or lower.

The present invention is also directed to a GaN crystalline substrate composed of a GaN crystal obtained by any one of the above-described methods for producing a GaN crystal.

The present invention is also directed to a product including the GaN crystalline substrate.

### Effects of the Invention

According to the present invention, it is possible to provide a GaₓIn₁₋ₓN (0≤x≤1) crystal production method capable of producing a GaₓIn₁₋ₓN (0≤x≤1) crystal having good crystallinity, a GaₓIn₁₋ₓN (0≤x≤1) crystalline substrate obtained by using such a production method, and a product including the GaₓIn₁₋ₓN (0≤x≤1) crystalline substrate.

According to the present invention, it is also possible to provide a GaN crystal production method capable of producing a GaN crystal having good crystallinity, a GaN crystalline substrate obtained by using such a production method, and a product including the GaN crystalline substrate.

### Brief Description of the Drawings

Fig. 1 is a schematic diagram showing the structure of one preferred example of production equipment for use in a method for producing a GaN crystal according to the present invention.
Fig. 2 is a schematic diagram showing the structure of one example of production equipment for use in a conventional method for producing a GaN crystal.
Fig. 3 is a schematic diagram showing the structure of another preferred example of production equipment for use in the method for producing a GaN crystal according to the present invention.

### Description of the Reference Signs

1: quartz reaction tube, 2, 3: gas inlet tube, 4: gallium source boat, 5, 6, 11: heater, 7: base substrate, 8: exhaust gas treatment apparatus, 9: power supply, 10: wire, 12: GaN crystal, 13: high frequency coil, 14: carbon support plate

### Best Modes for Carrying Out the Invention

Hereinbelow, one example of the present invention will be described with reference to a case where a GaN crystal is produced by growing a GaN crystal on the surface of a base substrate composed of a GaN crystal. It is to be noted that, in the drawings of the present invention, the same reference numerals designate the same parts or corresponding parts.

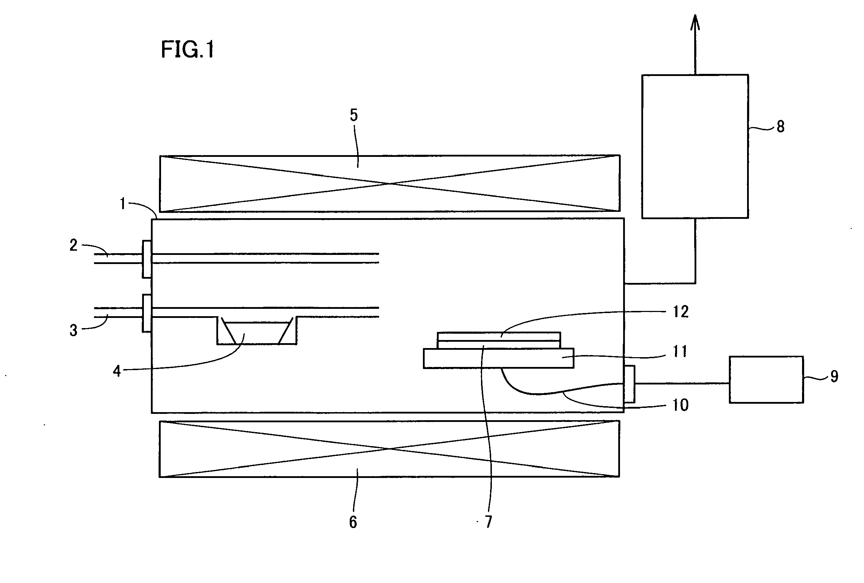

Fig. 1 is a schematic diagram showing the structure of one preferred example of production equipment for use in a method for producing a GaN crystal according to the present invention. The production equipment shown in Fig. 1 includes a quartz reaction tube 1 as a reactor, gas inlet tubes 2 and 3 for introducing a gas into quartz reaction tube 1, heaters 5 and 6 provided outside quartz reaction tube 1, and an exhaust gas treatment apparatus 8 connected to quartz reaction tube 1.

Inside quartz reaction tube 1 of the production equipment having such a structure described above, a base substrate 7 and a gallium source boat 4 containing gallium therein are provided, and a heater 11 is provided on the back surface side of base substrate 7. In this regard, it is to be noted that heater 11 is connected to a power supply 9 through a wire 10 made of, for example, molybdenum (Mo).

First of all, at least one carrier gas selected from the group consisting of, for example, nitrogen gas, argon gas, and hydrogen gas is introduced through gas inlet tubes 2 and 3 into quartz reaction tube 1, and at the same time, heaters 5 and 6 provided outside quartz reaction tube 1 and heater 11 provided on the back surface side of base substrate 7 are heated. By heating heaters 5 and 6, gallium source boat 4 and base substrate 7 are heated. By heating heater 11, the temperature of base substrate 7 is further increased.

In this regard, the temperature of quartz reaction tube heated by heaters 5 and 6 provided outside quartz reaction tube 1 is preferably 800°C or higher but 1100°C or lower, more preferably 800°C or higher but 950°C or lower. If the temperature of quartz reaction tube heated by heaters 5 and 6 is lower than 800°C, there is a fear that gallium source boat 4 is insufficiently heated and therefore the reaction between a halogen gas and gallium is suppressed during the growth of a GaN crystal (which will be described later), thus resulting in a decrease in the production of gallium halide required for the growth of a GaN crystal and in generation of a large amount of droplets of byproducts other than GaN or gallium droplets. If the temperature of quartz reaction tube heated by heaters 5 and 6 is higher than 1100°C, quartz reaction tube 1 is melted. In a case where the temperature of quartz reaction tube heated by heaters 5 and 6 is higher than 950°C, mass productivity tends to be poor because heating by heaters 5 and 6 is likely to accelerate the deterioration of quartz reaction tube 1 and shorten the lifetime of quartz reaction tube 1, and therefore quartz reaction tube 1 cannot be used repeatedly. On the other hand, by setting the temperature of quartz reaction tube heated by heaters 5 and 6 to a temperature of 800°C or higher but 950°C or lower, it is possible to effectively prevent unintended impurities from becoming airborne during the growth of a GaN crystal, thereby suppressing the incorporation of such unintended impurities into a GaN crystal. In addition, by setting the temperature of quartz reaction tube heated by heaters 5 and 6 to a temperature of 800°C or higher but 950°C or lower, it is possible to suppress the consumption of a material gas and therefore the efficiency of GaN crystal production (that is, the ratio of the amount of a grown GaN crystal to the amount of a supplied material) tends to be improved because, for example, the reaction of the material gas is prevented from occurring before the material gas reaches base substrate 7 to avoid the adhesion of a resultant product to quartz reaction tube 1.

The temperature of base substrate 7 heated by heater 11 provided on the back surface side of base substrate 7 is preferably higher than 950°C but 1400°C or lower, more preferably higher than 1100°C but 1400°C or lower, even more preferably higher than 1150°C but 1400°C or lower. If the temperature of base substrate 7 is higher than 1400°C, there is a fear that during the growth of a GaN crystal (which will be described later), the decomposition rate of a GaN crystal is significantly higher than the production rate of a GaN crystal, thus resulting in a reduction in the growth rate of a GaN crystal. The crystallinity of a grown GaN crystal tends to be higher when the temperature of base substrate 7 is higher (that is, for example, the temperature increases to 950°C, 1100°C, and 1150°C in order).

Particularly, in a case where a GaN crystal is made to grow on the surface of base substrate 7 made of gallium nitride, the temperature of base substrate 7 during the growth of a GaN crystal is preferably higher than 950°C but 1300°C or lower, more preferably higher than 1100°C but 1300°C or lower, even more preferably higher than 1150°C but 1250°C or lower. This is because the present inventors have found that when the temperature of base substrate 7 made of gallium nitride is higher (that is, for example, the temperature increases to 950°C, 1100°C, and 1150°C in order), the crystallinity of a grown GaN crystal is higher, and in addition to that, fracture is less likely to occur in slices of a GaN crystal, grown on the surface of base substrate 7 heated to a higher temperature, during polishing so that the yield of GaN crystalline substrate production is improved. It is not exactly known why fracture is less likely to occur, but it can be considered that a GaN crystal grown at a higher temperature has a smaller number of stress concentration points. Further, in a case where a GaN crystal is made to grow on the surface of base substrate 7 made of gallium nitride, the temperature of base substrate 7 is preferably higher than 1150°C for the reason described above, but thermal decomposition of base substrate 7 composed of a GaN crystal is more likely to proceed when the temperature of base substrate 7 is higher. If the temperature of base substrate 7 exceeds 1300°C, decomposition of base substrate 7 tends to become conspicuous so that base substrate 7 is damaged. In a case where the temperature of base substrate 7 is higher than 1250°C but 1300°C or lower, decomposition of base substrate 7 is not conspicuous but proceeds to some extent. Therefore, in this case, a long GaN crystal cannot be grown because base substrate 7 tends to be damaged when a GaN crystal is made to grow for a long time.

In the present invention, by setting the temperature of quartz reaction tube heated by heaters 5 and 6 to, for example, a temperature of 800°C or higher but 950°C or lower and by setting the temperature of base substrate 7 to, for example, a temperature higher than 1100°C but 1400°C or lower or higher than 1150°C but 1400°C or lower, it is possible to heat gallium source boat 4 while preventing quartz reaction tube 1 from being melted due to heating by heaters 5 and 6, and to set the temperature of base substrate 7 to a temperature higher than the melting temperature of quartz reaction tube 1.

Particularly, in a case where a GaN crystal is made to grow on the surface of base substrate 7 made of gallium nitride, during the growth of a GaN crystal, by setting the temperature of quartz reaction tube heated by heaters 5 and 6 to a temperature of preferably 800°C or higher but 1100°C or lower, more preferably 800°C or higher but 950°C or lower and by setting the temperature of base substrate 7 to a temperature preferably higher than 950°C but 1300°C or lower, more preferably higher than 1100°C but 1300°C or lower, even more preferably higher than 1150°C but 1250°C or lower, that is, by setting the temperature of base substrate 7 to a temperature higher than the temperature of quartz reaction tube heated by heaters 5 and 6, it is possible to heat gallium source boat 4 while preventing quartz reaction tube 1 from being melted due to heating by heaters 5 and 6, to set the temperature of base substrate 7 to a temperature higher than the melting temperature of quartz reaction tube 1, to improve the crystallinity of a grown GaN crystal, and to improve the yield of GaN crystalline substrate production. It is to be noted that the temperature of quartz reaction tube heated by heaters 5 and 6 and the temperature of base substrate 7 are maintained substantially constant until the growth of a GaN crystal is completed.

Then, ammonia gas is introduced through gas inlet tube 2 into quartz reaction tube 1 together with the carrier gas, and at the same time, a halogen gas such as hydrogen chloride gas is introduced through gas inlet tube 3 into quartz reaction tube 1 together with the carrier gas.

Here, it is preferred that, during the growth of a GaN crystal, the partial pressure of the halogen gas and the partial pressure of the ammonia gas in quartz reaction tube 1 is 1 × 10⁻² atm or higher but 0.2 atm or lower and 5 × 10⁻² atm or higher but 0.9 atm or lower, respectively. This tends to allow a GaN crystal to grow at a rate of 10 µm/h or higher.

It is more preferred that, during the growth of a GaN crystal, the partial pressure of the halogen gas and the partial pressure of the ammonia gas in quartz reaction tube 1 is 2 × 10⁻² atm or higher but 0.1 atm or lower and 0.2 atm or higher but 0.7 atm or lower, respectively. This tends to allow a GaN crystal to grow at a rate of 30 µm/h or higher without growing a polycrystalline GaN crystal.

In a case where the halogen gas introduced into quartz reaction tube 1 through gas inlet tube 3 is hydrogen chloride gas, the hydrogen chloride gas that has reached gallium source boat 4 reacts with gallium contained in gallium source boat 4 to form a gallium halide gas, that is, gallium chloride (GaCl) gas.

Then, a material gas containing the gallium halide gas and the ammonia gas reaches the surface of heated base substrate 7, and a GaN crystal 12 is grown on the surface of base substrate 7 by the reaction of the material gas containing the gallium halide gas and the ammonia gas.

After the completion of the growth of GaN crystal 12, the temperature of GaN crystal 12 is decreased to around room temperature, and base substrate 7 having GaN crystal 12 grown on the surface thereof is taken out of quartz reaction tube 1.

Thereafter, base substrate 7 is removed by, for example, grinding to obtain GaN crystal 12.

In the present invention, as described above, since base substrate 7 is individually heated by heater 11 provided inside quartz reaction tube 1 in addition to heating by heaters 5 and 6 provided outside quartz reaction tube 1, the temperature of base substrate 7 can be made higher than the temperature of quartz reaction tube 1 externally heated by heaters 5 and 6, thereby accelerating the reaction of the material gas, containing the gallium halide gas and the ammonia gas, in quartz reaction tube 1 without melting reaction quartz tube 1, and thereby improving the crystallinity of GaN crystal 12.

In addition to that, by individually heating base substrate 7, the temperature of quartz reaction tube 1 externally heated can be made lower than a temperature at which the deterioration of quartz reaction tube 1 proceeds, and therefore quartz reaction tube 1 can be repeatedly used, thereby improving mass productivity.

Thus obtained GaN crystal 12 is subjected to mirror surface polishing, and then a damaged layer caused by polishing is removed to produce a GaN crystalline substrate. Alternatively, GaN crystal 12 may be cut into slices having a predetermined thickness before mirror surface polishing. Also in this case, a damaged layer caused by polishing is removed to produce a GaN crystalline substrate. In this regard, the cutting direction of GaN crystal 12 is not particularly limited, and may be parallel or inclined at any angle to the surface of base substrate 7 which has not yet been removed.

It is to be noted that a description has been made above with reference to the production of a GaN crystal, but according to the present invention, it is also possible to produce an InN crystal by using a material gas containing an indium halide gas, such as indium chloride gas, formed by the reaction between a halogen gas, such as hydrogen chloride gas, and indium contained in an indium source boat provided instead of the gallium source boat containing gallium therein. As a matter of course, according to the present invention, it is also possible to produce a GaₓIn₁₋ₓN (0≤x≤1) crystal other than a GaN crystal and an InN crystal by using a material gas containing both a gallium halide gas and an indium halide gas.

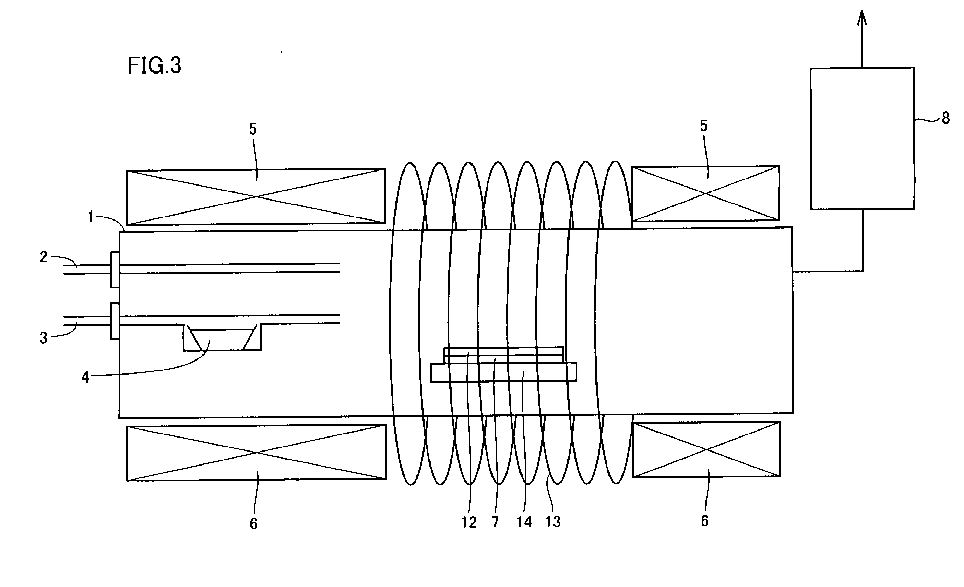

In the present invention, a base substrate may be heated using a high-frequency induction heating system. In this case, for example, as shown in Fig. 3, base substrate 7 is placed on a carbon support plate 14, a high frequency coil 13 is wound around at least a part of the outer periphery of quarts reaction tube 1 corresponding to the position of base substrate 7, and carbon support plate 14 is inductively heated by applying high-frequency electric current to high-frequency coil 13 to heat base substrate 7 by resulting heat.

A base substrate to be used in the present invention is preferably made of any one of silicon, sapphire, silicon carbide (SiC), gallium nitride (GaN) and aluminum nitride (AIN). Particularly, in a case where a base substrate is made of gallium nitride, it shows especially excellent lattice matching with GaₓIn₁₋ₓN (0≤x≤1), and therefore it is possible to produce a GaₓIn₁₋ₓN (0≤x≤1) crystal having higher crystallinity.

In a case where a GaN crystal is made to grow on the surface of a base substrate, the base substrate is particularly preferably made of gallium nitride. In this case, since the base substrate and a GaN crystal to be grown on the surface of the base substrate have the same lattice constant, a grown GaN crystal has good crystallinity, thereby effectively preventing the occurrence of warpage or fracture in the grown GaN crystal.

Further, in a case where a GaN crystal is made to grow on the surface of a base substrate made of gallium nitride, the arithmetic mean roughness Ra of the surface of the base substrate is preferably 10 µm or less, more preferably 1 µm or less. By setting the arithmetic mean roughness Ra of the surface of the base substrate to 10 µm or less, it is possible to effectively prevent the occurrence of fracture, resulting from the base substrate, during the growth of a GaN crystal. By setting the arithmetic mean roughness Ra of the surface of the base substrate to 1 µm or less, it is possible to further enhance such an effect. In this regard, it is to be noted that in the present invention, the term "arithmetic mean roughness Ra" means an arithmetic mean roughness Ra defined in JIS B0601 2001.

In the present invention, from the viewpoint of improving the purity of a GaₓIn₁₋ₓ N (0≤x≤1) crystal, the impurity concentration of a grown GaₓIn₁₋ₓN (0≤x≤1) crystal is preferably 1 × 10¹⁸ cm⁻³ or less. By using the HVPE method described above, it is possible to reduce the incorporation of impurities from the background, thereby allowing a high-purity GaₓIn₁₋ₓN (0≤x≤1) crystal to grow.

Although a description has been made above with reference to the production of a GaN crystalline substrate from a GaN crystal, it goes without saying that according to the present invention, it is also possible to produce a GaₓIn₁₋ₓN (0≤x≤1) crystalline substrate from a GaₓIn₁₋ₓN (0≤x≤1) crystal in the same manner as in the case of a GaN crystal.

Further, a description has been made above with reference to a case where a GaN crystal is made to grow on the surface of a base substrate, but according to the present invention, it is also possible to grow a GaₓIn₁₋ₓN (0≤x≤1) crystal on some kind of intermediate layer formed on the surface of the base substrate.

In addition, according to the present invention, it is also possible to grow a GaₓIn₁₋ₓN (0≤x≤1) crystal which contains, as an impurity, at least one selected from the group consisting of carbon, magnesium, iron, beryllium, zinc, vanadium, and antimony at a concentration of 1 × 10¹⁷ cm⁻³ or higher, and which has a specific resistance of 1 × 10⁴ Ωcm or higher. As described above, since the incorporation of impurities from the background can be reduced by using an HVPE method, it is easy to intentionally control the amount of the impurity to be doped into a GaₓIn₁₋ₓN (0≤x≤1) crystal, which tends to allow an insulating GaₓIn₁₋ₓN (0≤x≤1) crystal, having a specific resistance of 1 × 10⁴ Ωcm or higher, to be easily obtained. In this regard, in a case where two or more kinds of the impurities are contained in a GaₓIn₁₋ₓN (0≤x≤1) crystal, the total concentration of these impurities should be 1 × 10¹⁷ cm⁻³ or higher. It is to be noted that, in the present invention, the term "specific resistance" means a specific resistance of a GaₓIn₁₋ₓN (0≤x≤1) crystal at 25°C.

In addition, according to the present invention, it is also possible to grow a GaₓIn₁₋ₓN (0≤x≤1) crystal which contains, as an n-type impurity, at least one selected from the group consisting of oxygen, silicon, sulfur, germanium, selenium, and tellurium at a concentration of 1 × 10¹⁷ cm⁻³ or higher, and which has a specific resistance of 1 Ωcm or lower. As described above, since the incorporation of impurities from the background can be reduced by using an HVPE method, it is easy to intentionally control the amount of the impurity to be doped into a GaₓIn₁₋ₓN (0≤x≤1) crystal, which tends to allow a conductive GaₓIn₁₋ₓN (0≤x≤1) crystal, having a specific resistance of 1 Ωcm or lower, to be easily obtained. In this regard, in a case where two or more kinds of the impurities are contained in a GaₓIn₁₋ₓN (0≤x≤1) crystal, the total concentration of these impurities should be 1 × 10¹⁷ cm⁻³ or higher.

In addition, according to the present invention, it is also possible to grow a GaₓIn₁₋ₓN (0≤x≤1) crystal which contains, as an impurity, at least one selected from the group consisting of carbon, oxygen, and silicon, and which has an n_{eff} of 1 × 10¹⁷ cm⁻³ or higher but 1 × 10¹⁹ cm⁻³ or lower, the n_{eff} being represented by the following formula: n_{eff} = nₒ + nₛᵢ - n_{c} (where n_{c} is a carbon content, nₒ is an oxygen content, and nₛᵢ is a silicon content), and which has a specific resistance of 0.1 Ωcm or lower. In this regard, in a case where the n_{eff} is lower than 1 × 10¹⁷ cm⁻³, the specific resistance tends to be increased. On the other hand, in a case where the n_{eff} is higher than 1 × 10¹⁹ cm⁻³, the crystallinity of a GaₓIn₁₋ₓN (0≤x≤1) crystal tends to be reduced.

In addition, according to the present invention, it is also possible to grow a GaₓIn₁₋ₓN (0≤x≤1) crystal which contains, as impurities, carbon, oxygen, and silicon, and which has a carbon content n_{c} of 5 × 10¹⁵ cm⁻³ or higher but lower than 1 × 10¹⁷ cm⁻³, an oxygen content nₒ of 1 × 10¹⁷ cm⁻³ or higher but 2 × 10¹⁸ cm⁻³ or lower, and a silicon content nₛᵢ of 1 × 10¹⁷ cm⁻³ or higher but 2 × 10¹⁸ cm⁻³ or lower, and which has an n_{eff} of 1 × 10¹⁷ cm⁻³ or higher but 1 × 10¹⁹ cm⁻³ or lower, the n_{eff} being represented by the following formula: n_{eff} = nₒ + nₛᵢ - n_{c}, and which has a specific resistance of 0.01 Ωcm or higher but 0.1 Ωcm or lower. In this regard, in a case where the oxygen content nₒ or the silicon content nₛᵢ is higher than 2 × 10¹⁸ cm⁻³, fracture is likely to occur in a GaₓIn₁₋ₓ N (0≤x≤1) crystal.

In the present invention, in the case of producing a GaₓIn₁₋ₓN (0≤x≤1) crystalline substrate, a GaₓIn₁₋ₓN (0≤x≤1) crystal is preferably grown to have a thickness of 200 µm or more, and in the case of producing a GaN crystalline substrate, a GaN crystal is preferably grown to have a thickness of 200 µm or more.

The GaₓIn₁₋ₓN (0≤x≤1) crystalline substrate compose of a GaₓIn₁₋ₓN (0≤x≤1) crystal according to the present invention can be used as a substrate for use in products such as semiconductor devices, for example, optical devices (e.g., light-emitting diodes, laser diodes), electronic devices (e.g., rectifiers, bipolar transistors, field-effect transistors, HEMTs) and semiconductor sensors (e.g., temperature sensors, pressure sensors, radiation sensors, visible-ultraviolet photodetectors), SAW (surface acoustic wave) devices, transducers, oscillators, MEMS parts, and piezoelectric actuators. Such products can be manufactured by laminating a semiconductor layer and/or a metal layer on the surface of the GaₓIn₁₋ₓN (0≤x≤1) crystalline substrate according to the present invention.

### Examples

### (Example 1)

A base substrate 7 composed of a gallium nitride (GaN) crystal subjected to mirror surface polishing and removal of a damaged layer caused by polishing, and a gallium source boat 4 containing gallium therein were placed in a quartz reaction tube 1 shown in Fig. 1. The diameter and thickness of base substrate 7 were 2 inches and 400 µm, respectively. The surface of base substrate 7 had a surface orientation of (001).

Then, high-purity hydrogen gas as a carrier gas was introduced through gas inlet tubes 2 and 3 into quartz reaction tube 1, and at the same time, the temperature of quartz reaction tube heated by heaters 5 and 6 was increased to 950°C and base substrate 7 was individually heated by a heater 11 provided on the back surface side of base substrate 7 so that the temperature of base substrate 7 was 1200°C.

Subsequently, while the temperature of quartz reaction tube heated by heaters 5 and 6 was kept at 950°C and the temperature of base substrate 7 was kept at 1200°C, ammonia gas was introduced through gas inlet tube 2 into quartz reaction tube 1 together with the hydrogen gas, and hydrogen chloride gas was introduced through gas inlet tube 3 into quartz reaction tube 1 together with the hydrogen gas. The hydrogen chloride gas was reacted with gallium contained in gallium source boat 4 to form gallium chloride gas, and then a GaN crystal 12 was grown on the surface of base substrate 7 by the reaction of a material gas containing the gallium chloride gas and the ammonia gas. It is to be noted that during the growth of GaN crystal 12, the partial pressure of the hydrogen chloride gas and the partial pressure of the ammonia gas in quartz reaction tube 1 were controlled so that GaN crystal 12 was grown at a rate of 30 µm/h or higher without growing a polycrystal. More specifically, during the growth of GaN crystal 12, the partial pressure of the hydrogen chloride gas in quartz reaction tube 1 was controlled within a range of 2 × 10⁻² atm to 0.1 atm and the partial pressure of the ammonia gas in quartz reaction tube 1 was controlled within a range of 0.2 atm to 0.7 atm.

After GaN crystal 12 having a thickness of 400 µm was grown on the surface of base substrate 7 at that grown rate, the temperature of GaN crystal 12 was decreased to room temperature. Then, base substrate 7 having GaN crystal 12 grown on the surface thereof was taken out of quartz reaction tube 1. Base substrate 7 was removed by grinding, thus obtained GaN crystal 12 was subjected to mirror surface polishing, and a damaged layer caused by polishing was removed to produce a GaN crystalline substrate.

The crystallinity of the GaN crystalline substrate was analyzed by XRD (X-ray diffraction), and as a result, the full width at half maximum of the rocking curve for (004) plane of the GaN crystalline substrate was 40 seconds. From the result, it was found that the GaN crystalline substrate had good crystallinity.

Further, an area within a 10 µm square of the GaN crystalline substrate was observed by AFM (Atomic Force Microscope), and as a result, it was found that the GaN crystalline substrate had a good RMS (Root Mean Square) surface roughness of 50 nm or less.

Furthermore, the GaN crystalline substrate was analyzed by SIMS (Secondary Ion Mass Spectrometry), and as a result, it was found that the GaN crystalline substrate contained, as a main impurity, oxygen at a concentration of about 2 × 10¹⁷ cm⁻³, and that the total concentration of all impurities contained in the GaN crystalline substrate was 1 × 10¹⁸ cm⁻³ or less.

### (Example 2)

A GaN crystal 12 shown in Fig. 1 was made to grow to have a thickness of 5 mm in the same manner and under the same conditions as in Example 1, and then a base substrate 7 made of gallium nitride was completely removed by grinding. Then, GaN crystal 12 was sliced in the direction parallel to the surface of base substrate 7, on which GaN crystal 12 had been grown, to produce four GaN crystal slices having a thickness of 500 µm. Each of these four GaN crystal slices was subjected to mirror surface polishing, and then a damaged layer caused by polishing was removed. In this way, four GaN crystalline substrates were produced.

The crystallinity of these four GaN crystalline substrates was analyzed by XRD, and as a result, the full width at half maximum of the rocking curve for (004) plane of each of the GaN crystalline substrates was 40 seconds or less. From the result, it was found that all the GaN crystalline substrates had good crystallinity.

Further, an area within a 10 µm square of each of these four GaN crystalline substrates was observed by AFM, and as a result, it was found that each of the GaN crystalline substrates had a good RMS surface roughness of 50 nm or less.

Furthermore, each of these four GaN crystalline substrates was analyzed by SIMS, and as a result, it was found that each of the GaN crystalline substrates contained, as a main impurity, oxygen at a concentration of about 2 × 10¹⁷ cm⁻³, and that the total concentration of all impurities contained in each of the GaN crystalline substrates was 1 × 10¹⁸ cm⁻³ or less.

### (Example 3)

A GaN crystal 12 containing silicon as an n-type impurity was made to grow on the surface of a base substrate 7 shown in Fig. 1 in the same manner and under the same conditions as in Example 1 except that dichlorosilane (SiH₂Cl₂) was introduced into a quartz reaction tube 1 in addition to the hydrogen chloride gas and the ammonia gas. Then, base substrate 7 was removed to produce silicon-containing GaN crystal 12 having a thickness of 400 µm.

Then, GaN crystal 12 obtained by removing base substrate 7 by grinding was subjected to mirror surface polishing, and a damaged layer caused by polishing was removed to produce a GaN crystalline substrate.

The crystallinity of the GaN crystalline substrate was analyzed by XRD, and as a result, the full width at half maximum of the rocking curve for (004) plane of the GaN crystalline substrate was 40 seconds. From the result, it was found that the GaN crystalline substrate had good crystallinity.

Further, the GaN crystalline substrate was analyzed by SIMS, and as a result, it was found that the GaN crystalline substrate contained, as a main impurity, silicon at a concentration of about 1 × 10¹⁸ cm⁻³.

As described above, dichlorosilane was used as a silicon source in Example 3, but it can be considered that the same result as Example 3 can be obtained even when silicon tetrachloride (SiCl₄) is used instead of dichlorosilane. In addition, it can be considered that even when dichlorosilane and silicon tetrachloride are used together, the same result as Example 3 can be obtained. In addition, it can be considered that even when a silicon source other than dichlorosilane and silicon tetrachloride is used, the same result as Example 3 can be obtained.

### (Example 4)

A base substrate 7 composed of a gallium nitride (GaN) crystal subjected to mirror surface polishing and removal of a damaged layer caused by polishing was placed on a carbon support plate 14 provided in a quartz reaction tube 1 shown in Fig. 3. The diameter and thickness of base substrate 7 were 2 inches and 400 µm, respectively. The surface of base substrate 7 had a surface orientation of (001). Further, a gallium source boat 4 containing gallium therein was placed in quartz reaction tube 1.

Then, high-purity hydrogen gas as a carrier gas was introduced through gas inlet tubes 2 and 3 into quartz reaction tube 1, and at the same time, the temperature of quartz reaction tube heated by heaters 5 and 6 was increased to 950°C and carbon support plate 14 was high-frequency induction heated by applying high-frequency electric current to a high-frequency coil wound around a part of the outer periphery of quartz reaction tube corresponding to the position of base substrate 7 so that the temperature of base substrate 7 was 1200°C.

Subsequently, while the temperature of quartz reaction tube heated by heaters 5 and 6 was kept at 950°C and the temperature of base substrate 7 was kept at 1200°C, ammonia gas was introduced through gas inlet tube 2 together with the hydrogen gas, and hydrogen chloride gas was introduced through gas inlet tube 3 together with the hydrogen gas. The hydrogen chloride gas was reacted with gallium contained in gallium source boat 4 to form gallium chloride gas, and then a GaN crystal 12 was grown on the surface of base substrate 7 by the reaction of a material gas containing the gallium chloride gas and the ammonia gas. It is to be noted that during the growth of GaN crystal 12, the partial pressure of the hydrogen chloride gas and the partial pressure of the ammonia gas in quartz reaction tube 1 were controlled so that GaN crystal 12 was grown at a rate of 30 µm/h or higher without growing a polycrystal. More specifically, during the growth of GaN crystal 12, the partial pressure of the hydrogen chloride gas in quartz reaction tube 1 was controlled within a range of 2 × 10⁻² atm to 0.1 atm and the partial pressure of the ammonia gas in quartz reaction tube 1 was controlled within a range of 0.2 atm to 0.7 atm.

After GaN crystal 12 having a thickness of 400 µm was grown on the surface of base substrate 7 at that grown rate, the temperature of GaN crystal 12 was decreased to room temperature. Then, base substrate 7 having GaN crystal 12 grown on the surface thereof was taken out of quartz reaction tube 1. Base substrate 7 was removed by grinding, thus obtained GaN crystal 12 was subjected to mirror surface polishing, and a damaged layer caused by polishing was removed to produce a GaN crystalline substrate.

No fracture was observed in the GaN crystalline substrate. The crystallinity of the GaN crystalline substrate was analyzed by XRD, and as a result, the full width at half maximum of the rocking curve for (004) plane of the GaN crystalline substrate was 40 seconds. From the result, it was found that the GaN crystalline substrate had good crystallinity.

Further, the GaN crystalline substrate was analyzed by SIMS, and as a result, it was found that the GaN crystalline substrate contained, as a main impurity, oxygen at a concentration of about 2 × 10¹⁷ cm⁻³, and that the total concentration of all impurities contained in the GaN crystalline substrate was 1 × 10¹⁸ cm⁻³ or less.

### (Comparative Example 1)

A GaN crystal was made to grow in the same manner as in Example 1 except that production equipment shown in Fig. 2 was used and that the temperature of a quartz reaction tube 1 heated by heaters 5 and 6 shown in Fig. 2 was 1050°C and a base substrate 7 was not individually heated.

Then, base substrate 7 was removed by grinding, thus obtained GaN crystal 12 was subjected to mirror surface polishing, and a damaged layer caused by polishing was removed to produce a GaN crystalline substrate.

The crystallinity of the GaN crystalline substrate was analyzed by XRD, and as a result, the full width at half maximum of the rocking curve for (004) plane of the GaN crystalline substrate was 100 seconds, which was very larger than those of Examples 1 to 4. From the result, it was found that the GaN crystal of Comparative Example 1 was inferior in crystallinity to those of Examples 1 to 4.

From the results, it has been found that the crystallinity of a GaN crystal can be improved by heating a base substrate to a higher temperature in addition to external heating of a quartz reaction tube.

### (Example 5)

In the same manner as in Example 1, a GaN crystal 12 was made to grow to have a thickness of 400 µm while the temperature of a quartz reaction tube heated by heaters 5 and 6 shown in Fig. 1 was kept at 850°C and the temperature of a base substrate 7 composed of a GaN crystal was kept at 1200°C. During the growth of GaN crystal 12, the partial pressures of gases constituting a material gas were controlled so that the growth rate of GaN crystal 12 was 200 µm/h.

At the same partial pressures of the gases, a GaN crystal 12 was made to grow in the same manner as described above while the temperature of a quartz reaction tube heated by heaters 5 and 6 was kept at 1050°C and the temperature of a base substrate 7 was kept at 1200°C. As a result, the growth rate of GaN crystal 12 was changed to 50 µm/h.

From the result of Example 5, it has been found that the efficiency of production of GaN crystal 12 at the time when the temperature of quartz reaction tube heated by heaters 5 and 6 is 850°C is four times higher than that at the time when the temperature of quartz reaction tube heated by heaters 5 and 6 is 1050°C.

### (Example 6)

In the same manner and under the same conditions as in Example 1, a GaN crystal 12 was made to grow to have a thickness of 10 mm while the temperature of a base substrate 7 composed of a GaN crystal was kept at 1200°C. Then, grown GaN crystal 12 was sliced and subjected to mirror surface polishing to produce ten GaN crystalline substrates each having a thickness of 400 µm. In these ten GaN crystalline substrates, no fracture was observed.

In this regard, it is to be noted that in a case where a GaN crystal 12 was made to grow in the same manner and under the same conditions as in Example 1 except that the temperature of base substrate 7 was kept at 1050°C, fracture was observed in three GaN crystalline substrates out of ten GaN crystalline substrates.

### (Example 7)

As base substrates 7 shown in Fig. 1, ten base substrates composed of a GaN crystal having an arithmetic mean surface roughness Ra of 0.1 µm or more but 0.5 µm or less and ten base substrates composed of a GaN crystal having an arithmetic mean surface roughness Ra of 15 µm or more but 20 µm or less were prepared. Then, a GaN crystal 12 having a thickness of 10 mm was made to grow on the surface of each base substrate 7 in the same manner and under the same conditions as in Example 1.

In a case where GaN crystal 12 was made to grow on the surface of each of ten base substrates 7 composed of a GaN crystal having an arithmetic mean surface roughness Ra of 0.1 µm or more but 0.5 µm or less, no fracture was observed in GaN crystal 12 grown on each of these ten base substrates 7.

On the other hand, in a case where GaN crystal 12 was made to grow on the surface of each of ten base substrates 7 composed of a GaN crystal having an arithmetic mean surface roughness Ra of 15 µm or more but 20 µm or less, fracture was observed in GaN crystal 12 grown on each of three base substrates 7 out of ten base substrates 7.

### (Example 8)

A GaN crystal 12 containing, as an impurity, iron was made to grow on the surface of a base substrate 7 shown in Fig. 1 in the same manner and under the same conditions as in Example 1 except that iron chloride gas, formed by the reaction between iron and hydrogen chloride gas, was used in addition to the hydrogen chloride gas and the ammonia gas. Then, base substrate 7 was removed to produce iron-containing GaN crystal 12 having a thickness of 400 µm.

Then, base substrate 7 was removed by grinding, thus obtained GaN crystal 12 was subjected to mirror surface polishing, and a damaged layer caused by polishing was removed to produce a GaN crystalline substrate.

The GaN crystalline substrate was analyzed by SIMS, and as a result, it was found that the concentration of iron contained as an impurity was about 1 × 10¹⁸ cm⁻³. The specific resistance of the GaN crystalline substrate at 25°C was about 1 × 10⁷ Ωcm.

### (Example 9)

A GaN crystal 12 containing, as an impurity, silicon was made to grow on the surface of a base substrate 7 shown in Fig. 1 in the same manner and under the same conditions as in Example 1 except that silicon tetrachloride gas was used in addition to the hydrogen chloride gas and the ammonia gas. Then, base substrate 7 was removed to produce silicon-containing GaN crystal 12 having a thickness of 400 µm.

Then, GaN crystal 12 obtained by removing base substrate 7 by grinding was subjected to mirror surface polishing, and a damaged layer caused by polishing was removed to produce a GaN crystalline substrate.

The GaN crystalline substrate was analyzed by SIMS, and as a result, it was found that the GaN crystalline substrate contained, as an impurity, silicon at a concentration of about 1 × 10¹⁸ cm⁻³, and contained, as unintended impurities, carbon and oxygen at concentrations of about 5 × 10¹⁷ cm⁻³ and about 2 × 10¹⁷ cm⁻³, respectively. The specific resistance of the GaN crystalline substrate at 25°C was about 0.01 Ωcm.

The embodiments and examples disclosed herein are to be considered in all respects illustrative and not restrictive. The scope of the present invention is defined by the appended claims rather than by the foregoing description, and all changes that fall within metes and bounds of the claims, or equivalence of such metes and bounds thereof are therefore intended to be embraced by the claims.

### Industrial Applicability

The present invention can be applied to the production of a GaₓIn₁₋ₓN (0≤x≤1) crystal, the production of a GaₓIn₁₋ₓN (0≤x≤1) crystalline substrate, and the production of a product including the GaₓIn₁₋ₓN (0≤x≤1) crystalline substrate. Particularly, the present invention can be preferably applied to the production of a GaN crystal, the production of a GaN crystalline substrate, and the production of a product including the GaN crystalline substrate.

## Claims

1. A method for producing a GaₓIn₁₋ₓN (0≤x≤1) crystal (12) by growing the GaₓIn₁₋ₓN (0≤x≤1) crystal (12) on the surface of a base substrate (7) by the reaction of a material gas, containing ammonia gas and at least one of a gallium halide gas and an indium halide gas, in a quartz reaction tube (1), wherein during the growth of said GaₓIn₁₋ₓN (0≤x≤1) crystal (12), said quartz reaction tube (1) is externally heated and said base substrate (7) is individually heated.

2. The method for producing a GaₓIn₁₋ₓN (0≤x≤1) crystal (12) according to claim 1, wherein said base substrate (7) is individually heated by a heater (11) provided on the back surface side of said base substrate (7).

3. The method for producing a GaₓIn₁₋ₓN (0≤x≤1) crystal (12) according to claim 1, wherein said base substrate (7) is individually heated by utilizing a high-frequency induction heating system.

4. The method for producing a GaₓIn₁₋ₓN (0≤x≤1) crystal (12) according to claim 1, wherein said gallium halide gas is formed by the reaction between gallium and a halogen gas.

5. The method for producing a GaₓIn₁₋ₓN (0≤x≤1) crystal (12) according to claim 4, wherein said halogen gas is hydrogen chloride gas.

6. The method for producing a GaₓIn₁₋ₓN (0≤x≤1) crystal (12) according to claim 1, wherein said indium halide gas is formed by the reaction between indium and a halogen gas.

7. The method for producing a GaₓIn₁₋ₓN (0≤x≤1) crystal (12) according to claim 6, wherein said halogen gas is hydrogen chloride gas.

8. The method for producing a GaₓIn₁₋ₓN (0≤x≤1) crystal (12) according to claim 1, wherein said base substrate (7) is made of any one of silicon, sapphire, silicon carbide, gallium nitride, and aluminum nitride.

9. The method for producing a GaₓIn₁₋ₓN (0≤x≤1) crystal (12) according to claim 1, wherein the grown GaₓIn₁₋ₓN (0≤x≤1) crystal (12) has an impurity concentration of 1 × 10¹⁸ cm⁻³ or less.

10. The method for producing a GaₓIn₁₋ₓN (0≤x≤1) crystal (12) according to claim 1, wherein the grown GaₓIn₁₋ₓN (0≤x≤1) crystal (12) contains, as an impurity, at least one selected from the group consisting of carbon, magnesium, iron, beryllium, zinc, vanadium, and antimony at a concentration of 1 × 10¹⁷ cm⁻³ or higher, and has a specific resistance of 1 × 10⁴ Ωcm or higher.

11. The method for producing a GaₓIn₁₋ₓN (0≤x≤1) crystal (12) according to claim 1, wherein the GaₓIn₁₋ₓN (0≤x≤1) crystal (12) is grown to dope with an n-type impurity.

12. The method for producing a GaₓIn₁₋ₓN (0≤x≤1) crystal (12) according to claim 11, wherein the grown GaₓIn₁₋ₓN (0≤x≤1) crystal (12) contains, as said n-type impurity, at least one selected from the group consisting of oxygen, silicon, sulfur, germanium, selenium, and tellurium at a concentration of 1 × 10¹⁷ cm⁻³ or higher, and has a specific resistance of 1 Ωcm or lower.

13. The method for producing a GaₓIn₁₋ₓN (0≤x≤1) crystal (12) according to claim 1, wherein the grown GaₓIn₁₋ₓN (0≤x≤1) crystal (12) contains, as an impurity, at least one selected from the group consisting of carbon, oxygen, and silicon, and has an n_{eff} of 1 × 10¹⁷ cm⁻³ or higher but 1 × 10¹⁹ cm⁻³ or lower, the n_{eff} being represented by the following formula: n_{eff} = nₒ + nₛᵢ - n_{c} (where n_{c} is a carbon content, nₒ is an oxygen content, and nₛᵢ is a silicon content), and has a specific resistance of 0.1 Ωcm or lower.

14. The method for producing a GaₓIn₁₋ₓN (0≤x≤1) crystal (12) according to claim 13, wherein the grown GaₓIn₁₋ₓN (0≤x≤1) crystal (12) has said carbon content n_{c} of 5 × 10¹⁵ cm⁻³ or higher but lower than 1 × 10¹⁷ cm⁻³, said oxygen content nₒ of 1 × 10¹⁷ cm⁻³ or higher but 2 × 10¹⁸ cm⁻³ or lower, said silicon content nₛᵢ of 1 × 10¹⁷ cm⁻³ or higher but 2 × 10¹⁸ cm⁻³ or lower, and a specific resistance of 0.01 Ωcm or higher but 0.1 Ωcm or lower.

15. The method for producing a GaₓIn₁₋ₓN (0≤x≤1) crystal (12) according to claim 1, wherein the grown GaₓIn₁₋ₓN (0≤x≤1) crystal (12) has a thickness of 200 µm or more.

16. The method for producing a GaₓIn₁₋ₓN (0≤x≤1) crystal (12) according to claim 1, wherein during the growth of said GaₓIn₁₋ₓN (0≤x≤1) crystal (12), the temperature of said base substrate (7) is higher than 1100°C but 1400°C or lower.

17. The method for producing a GaₓIn₁₋ₓN (0≤x≤1) crystal (12) according to claim 1, wherein during the growth of said GaₓIn₁₋ₓN (0≤x≤1) crystal (12), the temperature of said base substrate (7) is higher than 1150°C but 1400°C or lower.

18. The method for producing a GaₓIn₁₋ₓN (0≤x≤1) crystal (12) according to claim 1, wherein during the growth of said GaₓIn₁₋ₓN (0≤x≤1) crystal (12), the temperature of said quartz reaction tube (1) externally heated is 800°C or higher but 1100°C or lower, and the temperature of said base substrate (7) is higher than 1100°C but 1400°C or lower.

19. The method for producing a GaₓIn₁₋ₓN (0≤x≤1) crystal (12) according to claim 1, wherein during the growth of said GaₓIn₁₋ₓN (0≤x≤1) crystal (12), the temperature of said quartz reaction tube (1) externally heated is 800°C or higher but 950°C or lower, and the temperature of said base substrate (7) is higher than 950°C but 1400°C or lower.

20. A method for producing a GaₓIn₁₋ₓN (0≤x≤1) crystal (12) by growing the GaₓIn₁₋ₓN (0≤x≤1) crystal (12) on the surface of a base substrate (7) by the reaction of a material gas, containing ammonia gas and at least one of a gallium halide gas and an indium halide gas, in a quartz reaction tube (1), wherein during the growth of said GaₓIn₁₋ₓN (0≤x≤1) crystal (12), the temperature of said base substrate (7) is higher than 1100°C but 1400°C or lower.

21. A method for producing a GaₓIn₁₋ₓN (0≤x≤1) crystal (12) by growing the GaₓIn₁₋ₓN (0≤x≤1) crystal (12) on the surface of a base substrate (7) by the reaction of a material gas, containing ammonia gas and at least one of a gallium halide gas and an indium halide gas, in a quartz reaction tube (1), wherein during the growth of said GaₓIn₁₋ₓN (0≤x≤1) crystal (12), the temperature of said base substrate (7) is higher than 1150°C but 1400°C or lower.

22. A GaₓIn₁₋ₓN (0≤x≤1) crystalline substrate comprising a GaₓIn₁₋ₓN (0≤x≤1) crystal (12) obtained by the method for producing the GaₓIn₁₋ₓN (0≤x≤1) crystal (12) according to claim 1.

23. A product comprising the GaₓIn₁₋ₓN (0≤x≤1) crystalline substrate according to claim 22.

24. A method for producing a GaN crystal (12) by growing the GaN crystal (12) on the surface of a base substrate (7) by the reaction of a material gas, containing a gallium halide gas and ammonia gas, in a quartz reaction tube (1), wherein during the growth of said GaN crystal (12), said quartz reaction tube (1) is externally heated and said base substrate (7) is individually heated.

25. The method for producing a GaN crystal (12) according to claim 24, wherein said base substrate (7) is individually heated by a heater provided on the back surface side of said base substrate (7).

26. The method for producing a GaN crystal (12) according to claim 24, wherein said base substrate (7) is individually heated by utilizing a high-frequency induction heating system.

27. The method for producing a GaN crystal (12) according to claim 24, wherein said gallium halide gas is formed by the reaction between gallium and a halogen gas.

28. The method for producing a GaN crystal (12) according to claim 27, wherein said halogen gas is hydrogen chloride gas.

29. The method for producing a GaN crystal (12) according to claim 24, wherein the grown GaN crystal (12) has an impurity concentration of 1 × 10¹⁸ cm⁻³ or less.

30. The method for producing a GaN crystal (12) according to claim 24, wherein the grown GaN crystal (12) contains, as an impurity, at least one selected from the group consisting of carbon, magnesium, iron, beryllium, zinc, vanadium, and antimony at a concentration of 1 × 10¹⁷ cm⁻³ or higher, and has a specific resistance of 1 × 10⁴ Ωcm or higher.

31. The method for producing a GaN crystal (12) according to claim 24, wherein the GaN crystal (12) is grown to doped with an n-type impurity.

32. The method for producing a GaN crystal (12) according to claim 31, wherein the grown GaN crystal (12) contains, as said n-type impurity, at least one selected from the group consisting of oxygen, silicon, sulfur, germanium, selenium, and tellurium at a concentration of 1 × 10¹⁷ cm⁻³ or higher, and has a specific resistance of 1 Ωcm or lower.

33. The method for producing a GaN crystal (12) according to claim 24, wherein the grown GaN crystal (12) contains, as an impurity, at least one selected from the group consisting of carbon, oxygen, and silicon, and has an n_{eff} of 1 × 10¹⁷ cm⁻³ or higher but 1 × 10¹⁹ cm⁻³ or lower, the n_{eff} being represented by the following formula: n_{eff} = nₒ + nₛᵢ - n_{c} (where n_{c} is a carbon content, nₒ is an oxygen content, and nₛᵢ is a silicon content), and has a specific resistance of 0.1 Ωcm or lower.

34. The method for producing a GaN crystal (12) according to claim 33, wherein the grown GaN crystal (12) has said carbon content n_{c} of 5 × 10¹⁵ cm⁻³ or higher but lower than 1 × 10¹⁷ cm⁻³, said oxygen content nₒ of 1 × 10¹⁷ cm⁻³ or higher but 2 × 10¹⁸ cm⁻³ or lower, said silicon content nₛᵢ of 1 × 10¹⁷ cm⁻³ or higher but 2 × 10¹⁸ cm⁻³ or lower, and a specific resistance of 0.01 Ωcm or higher but 0.1 Ωcm or lower.

35. The method for producing a GaN crystal (12) according to claim 24, wherein the grown GaN crystal (12) has a thickness of 200 µm or more.

36. The method for producing a GaN crystal (12) according to claim 24, wherein said base substrate (7) is made of gallium nitride.

37. The method for producing a GaN crystal (12) according to claim 24, wherein the surface of said base substrate (7) has an arithmetic mean roughness Ra of 10 µm or less.

38. The method for producing a GaN crystal (12) according to claim 24, wherein during the growth of said GaN crystal (12), the temperature of said base substrate (7) is higher than 1100°C but 1300°C or lower.

39. The method for producing a GaN crystal (12) according to claim 24, wherein during the growth of said GaN crystal (12), the temperature of said base substrate (7) is higher than 1150°C but 1250°C or lower.

40. The method for producing a GaN crystal (12) according to claim 24, wherein during the growth of said GaN crystal (12), the temperature of said quartz reaction tube (1) externally heated is 800°C or higher but 1100°C or lower, and the temperature of said base substrate (7) is higher than 1100°C but 1300°C or lower.

41. The method for producing a GaN crystal (12) according to claim 24, wherein during the growth of said GaN crystal (12), the temperature of said quartz reaction tube (1) externally heated is 800°C or higher but 950°C or lower, and the temperature of said base substrate (7) is higher than 950°C but 1300°C or lower.

42. The method for producing a GaN crystal (12) according to claim 24, wherein during the growth of said GaN crystal (12), the temperature of said quartz reaction tube (1) externally heated is 800°C or higher but 1100°C or lower, and the temperature of said base substrate (7) is higher than 1150°C but 1250°C or lower.

43. The method for producing a GaN crystal (12) according to claim 24, wherein during the growth of said GaN crystal (12), the temperature of said quartz reaction tube (1) externally heated is 800°C or higher but 950°C or lower, and the temperature of said base substrate (7) is higher than 1150°C but 1250°C or lower.

44. A method for producing a GaN crystal (12) by growing the GaN crystal (12) on the surface of a base substrate (7) by the reaction of a material gas, containing a gallium halide gas and ammonia gas, in a quartz reaction tube (1), wherein during the growth of said GaN crystal (12), the temperature of said base substrate (7) is higher than 1100°C but 1300°C or lower.

45. A method for producing a GaN crystal (12) by growing the GaN crystal (12) on the surface of a base substrate (7) by the reaction of a material gas, containing a gallium halide gas and ammonia gas, in a quartz reaction tube (1), wherein during the growth of said GaN crystal (12), the temperature of said base substrate (7) is higher than 1150°C but 1250°C or lower.

46. A GaN crystalline substrate comprising a GaN crystal (12) obtained by the method for producing a GaN crystal (12) according to claim 24.

47. A product comprising the GaN crystalline substrate according to claim 46.
